# EUROPÄISCHE PATENTSCHRIFT

(11) **EP 0 929 367 B1**
(45) Veröffentlichungstag und Bekanntmachung des Hinweises auf die Patenterteilung: **10.01.2001**
(21) Anmeldenummer: 97909273.1
(22) Anmeldetag: 16.09.1997
(51) Int. Cl.: B08B 3/04, H01L 21/00

(54) **VERFAHREN UND VORRICHTUNG ZUM BEHANDELN VON SUBSTRATEN**
METHOD AND DEVICE FOR TREATING SUBSTRATES
PROCEDE ET DISPOSITIF DE TRAITEMENT DE SUBSTRATS

(30) Priorität: 03.10.1996 DE 19640848
(43) Veröffentlichungstag der Anmeldung: 21.07.1999
(73) Patentinhaber: STEAG MicroTech GmbH, 72124 Pliezhausen (DE)
(72) Erfinder: SCHÖNLEBER, Dietmar, D-72587 Römerstein (DE)
(86) Internationale Anmeldenummer: EP9705053
(87) Internationale Veröffentlichungsnummer: WO9814282

(56) Entgegenhaltungen:
- EP-A- 0 385 536
- DE-A- 19 546 990
- US-A- 4 722 752

## Beschreibung

Die Erfindung betrifft ein Verfahren zum Behandeln von Substraten, die in einem Behandlungsfluid behandelt und mit einer Hubvorrichtung ein- und ausgehoben werden. Die Erfindung betrifft weiterhin eine Vorrichtung zum Behandeln von Substraten in einem Behandlungsfluid, mit einer Hubvorrichtung.

Aus der DE 195 46 990 A1, die auf dieselbe Anmelderin wie die vorliegende Anmeldung zurückgeht, ist eine Anlage zur Behandlung und ein Trocknungsverfahren bekannt, bei der bzw. bei dem scheibenförmige Substrate, beispielsweise Halbleiterwafer, mit einem Hubmesser aus einem Substratträger über die Behandlungsfluid-Oberfläche angehoben und in Führungen einer Haube eingeführt werden. Nachdem das Behandlungsfuid aus dem Behandlungsbehälter abgeleitet wurde, werden die getrockneten Substrate wieder in den nunmehr ebenfalls trockenen Substratträger abgesenkt und mit diesem aus der Anlage entnommen.

Diese bekannte Vorrichtung und das bekannte Verfahren haben sich in der Praxis gut bewährt. Dennoch weisen sie Nachteile hinsichtlich des für diesen Trocknungsvorgang erforderlichen Zeitbedarf auf. Darüber hinaus muß für die Trocknung des Subtratträgers das Behandlungsfluid abgelassen werden, was nicht nur zeitaufwendig ist, sondern auch einen höheren Fluidbedarf erfordert. Da die Substrate beim Ausheben aus dem Behandlungsfluid in Führungen einer Haube geführt werden müssen, ist auch eine solche Haube notwendigerweise erforderlich. Insbesondere für quadratische oder rechteckige Substrate ist es jedoch nicht oder nur mit großen Schwierigkeiten und der Gefahr von Substratbrüchen möglich, die Substrate in Führungen der Haube zu führen.

Aus der EP 0 385 536 A1 ist ein Verfahren und eine Vorrichtung zum Trocknen von Substraten nach der Behandlung in einem Fluid bekannt, bei der die Substrate in Führungsschlitzen eines Fluidbehälters geführt und gehalten sind. Ein Anhebelement drückt die in den Führungsschlitzen des Fluidbehälters gehaltenen und geführten Substrate nach oben und in eine Hilfskassette, wobei die Substrate auch nach vollständigem Herausheben aus dem Behandlungsfluid weiterhin mit dem Hebeelement in Berührung stehen, das mit dem Behandlungsfluid benetzt ist. Die Trocknung der Substrate ist daher nicht sicher gewährleistet, insbesondere dann nicht, wenn das Hebeelement gleichzeitig auch die Halterung für die Substrate bildet und daher eine relativ große Berührungsfläche mit den Substraten aufweist.

Aus der U.S. 4 722 752 ist eine Vorrichtung und ein Verfahren zum Spülen und Trocknen von Halbleiter-Wafern bekannt, bei dem bzw. bei der die Wafer in Kassetten in die Behandlungsflüssigkeit eingesetzt und in den Kassetten in der Flüssigkeit gespült werden. Diese Kassetten stellen :für den Spülvorgang jedoch hohe Strömungswiderstände dar, so daß insbesondere auch dadurch, daß die Wafer seitlich über einen großen Oberflächenbereich hinweg von den in den Seitenwänden der Kassette ausgebildeten Rillen bzw. Nuten gehalten werden, nur begrenzt mit der Flüssigkeit umspült werden können. Die Spülfunktion ist daher bei der bekannten Vorrichtung nicht befriedigend. Aufgrund der Nuten und Kanten der Kassette wird die Kassette während der Aufwärtsbewegung durch die Oberfläche des Behandlungsfluids hinweg nicht vollständig oder nur mit großem Zeitaufwand getrocknet, weil die in den Nuten und Kanten befindliche Flüssigkeit durch Kapillarwirkung und durch die verringerte Möglichkeit des widerstandsfreien Abfließens nicht oder nur mit großem Zeitaufwand entfernt werden kann. Darüber hinaus bilden sich Tropfen an den untersten Stellen der aus dem Behandlungsfluid herausgehobenen Substrate. Diese letzten Tropfen, die eine große Wieder-Kontaminationsgefahr darstellen, benötigen zu ihrer Trocknung viel Zeit, die die Produktivität der Anlage einschränkt. Der Trocknungsvorgang bei dieser Vorrichtung ist daher sowohl hinsichtlich des Trocknungsergebnisses als auch hinsichtlich der für den Trocknungsvorgang erforderlichen Zeit unbefriedigend.

Der Erfindung liegt daher die Aufgabe zugrunde, ein Verfahren und eine Vorrichtung zum Ein- und Ausbringen von Substraten in ein bzw. aus einem Behandlungsfluid anzugeben bzw. zu schaffen, die bzw. das die genannten Nachteile bekannter Einrichtungen nicht aufweist und insbesondere einen schnellen, zuverlässigen Trocknungsvorgang und Aushub vor allem auch für quadratische bzw. rechteckige Substrate mit einfachen Mitteln und geringem Aufwand ermöglicht.

Diese Aufgabe wird bei einem Verfahren, bei dem die Substrate mit einer ersten Aufnahme teilweise aus dem Behandlungsfluid herausgehoben und danach von einer zweiten Aufnahme übernommen und vollständig aus dem Behandlungsfluid (8) herausgehoben werden, die beim Übernehmen der Substrate (3) trocken ist,erfindungsgemäß dadurch gelöst, daß sich an der tiefsten Stelle der Substrate bildende Tropfen mit einem Tropfen-Ableitelement abgeleitet werden. Beim Ausfahren der Substrate bildet sich jeweils ein letzter Tropfen an der tiefsten, untersten Stelle der Substrate, der nicht oder nur schlecht abtropft. Durch das Ableiten dieses Tropfens mittels eines Tropfenableitelements wird auch dieser Bereich schnell und zuverlässig getrocknet. Führungen außerhalb des Fluidbehälters, beispielsweise in einer Haube, sind nicht mehr erforderlich, sodaß Führungen in der Haube oder gegebenenfalls auch die Haube selbst nicht mehr erforderlich sind bzw. ist, und insbesondere auch quadratische bzw. rechteckige Substrate ohne die Gefahr eines Bruchs handhabbar sind.

Sofern die zweite Aufnahme nicht ohnehin trocken ist, wird gemäß einer besonders vorteilhaften Ausgestaltung der Erfindung die zweite Aufnahme getrocknet, bevor sie die Substrate übernimmt. Die zweite Aufnahme kann dabei vorzugsweise im gleichen Arbeitsgang wie die Substrate getrocknet werden. Die bereits getrocknete zweite Aufnahme kommt dabei vorzugsweise mit Bereichen der Substrate in Berührung, die bereits getrocknet sind, sich also bereits oberhalb der Fluidoberfläche befinden, über der sich auch die zweite Aufnahme bei Übernahme der Substrate befindet.

Die zweite Aufnahme hebt danach die Substratbereiche, die sich gegebenenfalls bei Übergabe der Substrate von der ersten Aufnahme zur zweiten Aufnahme noch im Behandlungsfluid befinden, vollständig aus diesem aus. Kein Substratbereich, der bereits getrocknet ist, kommt daher mit einem noch nicht getrockneten Aufnahmebereich in Berührung. Um dies zu erreichen, ist es nicht erforderlich, das Behandlungsfluid aus dem Fluidbehälter abzulassen.

Gemäß einer besonders vorteilhaften Ausführungsform der Erfindung werden die erste und die zweite Aufnahme in vertikaler Richtung relativ zueinander bewegt, wodurch eine zuverlässige, sichere Übernahme der Substrate von der ersten zur zweiten Aufnahme gewährleistet ist. Während dieses Übergabevorgangs werden die Substrate weiterhin mit einer im wesentlichen kontinuierlichen Geschwindigkeit ohne Anhalten oder sprunghafte Geschwindigkeitsänderung aus dem Behandlungsfluid gehoben, wodurch das Anhaften von Partikeln oder Verunreinigungen an den Substraten wesentlich verringert wird.

Gemäß einer weiteren Ausgestaltung der Erfindung werden die Substrate beim Beladen der Anlage bzw. Vorrichtung in bzw. auf die zweite Auflage gebracht und beim Entladen aus bzw. von der zweiten Auflage entnommen. Mit dem Verfahren ist also keine zusätzliche Führung oder kein zusätzlicher Träger für die Substrate erforderlich.

Das erfindungsgemäße Verfahren ist insbesondere im Zusammenhang mit einem Trocknungsvorgang nach dem Marangoni-Prinzip vorteilhaft einsetzbar, bei dem die zu trocknenden Substrate mit einem Gas oder Gasgemisch, beispielsweise mit Isopropylalkohol, Stickstoff oder einem Gemisch aus diesen Gasen, beaufschlagt werden, wodurch der Trocknungsvorgang wesentlich schneller abläuft.

Die gestellte Aufgabe wird weiterhin bei einer Vorrichtung mit einer ersten Aufnahme zum teilweisen Ausheben der Substrate aus dem Behandlungsfluid und einer zweiten Aufnahme zum Übernehmen der Substrate nach dem wenigstens teilweisen Ausheben durch die erste Aufnahme, wobei die zweite Aufnahme beim Übernehmen der Substrate trocken ist, durch ein Tropfenableitelement gelöst, das mit der untersten Stelle der Substrate wenigstens dann in Kontakt steht, wenn die Substrate vollständig aus dem Behandlungsfluid ausgehoben sind. Bei rechteckigen oder quadratischen Substraten ist dabei die unterste Stelle der Substrate eine Ecke des Substrats. Die damit erreichten Vorteile entsprechen denen, wie sie bereits im Zusammenhang mit dem erfindungsgemäßen Verfahren zuvor beschrieben wurden. Auch hier ist es vorteilhaft, wenn die zweite Aufnahme beim Übernehmen der Substrate von der ersten Aufnahme bereits trocken ist bzw. analog zum Trocknungsvorgang für die Substrate schon getrocknet ist, wenn die zweite Aufnahme ebenfalls aus dem Behandlungsfluid ausgehoben wird. Bereits getrocknete Bereiche der Substrate kommen dabei wiederum nur mit bereits getrockneten Bereichen der zweiten Aufnahme in Berührung, so daß die Substrate nicht wieder mit dem Fluid in Berührung kommen.

Gemäß einer vorteilhaften Ausführung der Erfindung ist die erste und zweite Aufnahme mit jeweils einem Transportschlitten verbunden, die entsprechend angetrieben und in ihren Bewegungsabläufen gesteuert werden, um die erste und zweite Aufnahme in der gewünschten Weise anzuheben und abzusenken.

Sehr vorteilhaft ist es dabei, wenn die Transportschlitten bzw. die erste und zweite Aufnahme relativ zueinander bewegbar sind. Vorzugsweise sind der Bewegungsablauf und/oder die Hubgeschwindigkeit der Transportschlitten im einzelnen, sowie deren Relativbewegung und/oder Relativgeschwindigkeit mit wenigstens einer Steuerkurve steuerbar. Vorrichtungen dieser Art für den Bewegungsablauf der Transportschlitten sind in der DE 195 46 990 A1 im einzelnen beschrieben. Um Wiederholungen zu vermeiden, wird auf diese Druckschrift verwiesen.

Es wird darauf hingewiesen, daß unter dem Begriff Substrat nicht nur Wafer, sondern Objekte aller Art zu verstehen sind, die einen Behandlungsvorgang in einem Behandlungsfluid und einem nachfolgenden Trocknungsvorgang zu unterziehen sind. Der Begriff Substrat umfaßt also nicht nur Halbleiterwafer, sondern insbesondere auch LCD-Scheiben, Compactdiscs, CD's, Flachbildschirme, Masken usw.

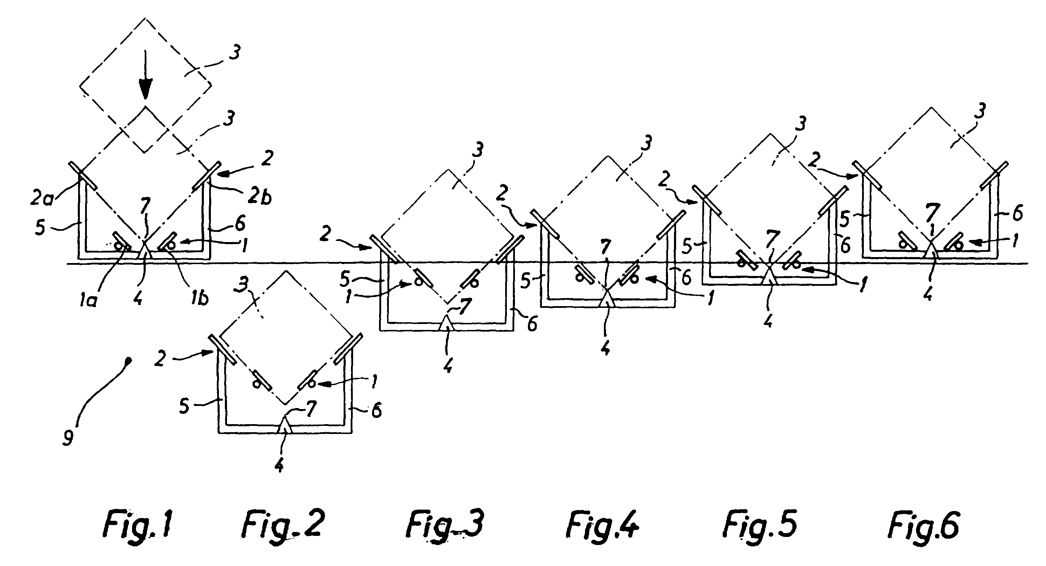

Die Erfindung sowie weitere Einzelheiten und Vorteile derselben wird bzw. werden nachfolgend anhand der Fig. 1 bis 6 erläutert, die in schematischer Darstellung die erfindungsgemäße Vorrichtung und den Ablauf des erfindungsgemäßen Verfahrens wiedergeben.

Die Fig. 1 bis 6 zeigen jeweils schematische Darstellungen einer ersten Aufnahme 1 mit Aufnahmebereichen 1a und 1b sowie eine zweite Aufnahme 2 mit Aufnahmebereichen 2a und 2b. Im dargestellten Ausführungsbeispiel wird die Erfindung im Zusammenhang mit der Verwendung von quadratischen Substraten 3 beschrieben, die - wie dies im weiteren ausgeführt wird - sowohl in der ersten Aufnahme 1 als auch in der zweiten Aufnahme 2 zu liegen kommen.

Mit der zweiten Aufnahme 2 ist ein Tropfenableitelement 4 in Form eines Messers über Arme 5, 6 verbunden, so daß die Spitze 7 des messerartigen Abtropfelements 4 in konstantem Abstand zur zweiten Aufnahme 2 steht und die untere Ecke des quadratischen Substrats 3 berührt, wenn sich die Substrate 3 in bzw. auf der Aufnahme 2 befinden.

Mit dem Bezugszeichen 8 ist jeweils die Fluid-Oberfläche des Behandlungsfluids 9 schematisch dargestellt, in die die Substrate ein- und aus dem die Substrate ausgebracht werden.

Gemäß Fig. 1 wird die Vorrichtung mit den Substraten 3 beladen, indem diese auf bzw. in die zweite Aufnahme 2 jeweils als Pakete parallel zueinander von oben und oberhalb der Fluidoberfläche 8 auf- bzw. eingesetzt werden. Damit die Substrate 3 parallel zueinander senkrecht in ihrer Lage verbleiben, weist die Aufnahme 2 bzw. deren Aufnahmebereiche 2a und 2b parallele Halterungsschlitze auf, in denen die Kanten der Substrate 3 liegen.

Die unteren Ecken der Substrate 3 berühren die Spitze 7 des Tropfen-Ableitelements 4, das beim Beladen der Vorrichtung gemäß Fig. 1 jedoch zunächst keine Funktion besitzt.

Nach dem Beladen der zweiten Aufnahme 2 mit den Substraten 3 gemäß Fig. 1 wird die erste und zweite Aufnahme 1, 2 so weit abgesenkt, daß die Substrate 3 vollständig in das Behandlungsfluid 9 eintauchen, wie dies in Fig. 2 gezeigt ist. In dieser Position werden die Substrate mit einem Behandlungsfluid, beispielsweise einem Spülfluid, behandelt, wie dies beispielsweise aus der DE 44 13 077 A1 bekannt ist.

Während der Fluidbehandlung der Substrate 3 oder auch erst danach wird die erste Aufnahme 1 relativ zur zweiten Aufnahme 2 angehoben, so daß die Substrate 3 in bzw. auf der ersten Aufnahme 1 liegen und von der zweiten Aufnahme 2 freikommen. Dieser Zustand ist in Fig. 2 dargestellt.

Nach der Behandlung der Substrate 3 im Behandlungsfluid 9 wird sowohl die erste als auch die zweite Aufnahme 1 bzw. 2 in der in Fig. 2 dargestellten Relativlage zueinander gleichzeitig und parallel angehoben, so daß die Substrate 3 gemäß Fig. 3 über die Fluidoberfläche 8 hinaus gelangen und im Bereich oberhalb der Fluidoberfläche 8 beispielsweise und vorzugsweise gemäß dem Marangoni-Prinzip getrocknet werden, das in der EP 0 385 536 A1 beschrieben ist. Die zweite Aufnahme 2 mit den Aufnahmebereichen 2a und 2b gelangt dabei ebenfalls über die Fluidoberfläche 8 und wird in entsprechender Weise getrocknet, wobei die zweite Aufnahme 2 nicht mit den Substraten 3 in Berührung steht. Die Substrate 3 werden während dieses Verfahrensschritts von der Aufnahme 1 gehalten.

Nachdem die Aufnahme 2 und die Kantenbereiche der Substrate 3, die bereits aus dem Behandlungsfluid 9 herausgehoben wurden, trocken sind, werden die erste Aufnahme 1 und die zweite Aufnahme 2 relativ zueinander so bewegt, daß die zweite Aufnahme 2 die Substrate 3 übernimmt, die dadurch von der ersten Aufnahme 1 freikommen, wie dies in Fig. 4 schematisch dargetellt ist. Die zweite Aufnahme 2 überholt also in ihrer Aufwärtsbewegung in diesem Hubbereich die erste Aufnahme 1.

Wie Fig. 5 zeigt, werden nunmehr die restlichen Bereiche der Substrate 3, die noch im Behandlungsfluid 9 eingetaucht waren, über die Fluidoberfläche 8 gehoben und getrocknet, ohne daß dabei die erste Aufnahme 1 stört, da sie während dieses Verfahrensschritts nicht mit den Substraten 3 in Berührung steht.

Nachdem die Substrate 3 vollständig über die Fluidoberfläche 8 angehoben sind, bewirkt das Abtropfelement 4, an dessen Spitze 7 die unteren Ecken der Substrate 3 anliegen, daß die jeweiligen, an den unteren Ecken der Substrate auftretenden letzten Tropfen abgeleitet werden. Dieser Zustand ist in Fig. 6 schematisch dargestellt, die auch die Position wiedergibt, in der die Substrate 3 entladen werden können, um in derselben Position entsprechend Position la danach wieder für den nächsten Beladungsvorgang bereitzustehen.

Die Aufnahmen 1, 2 sind mit nicht dargestellten Antriebsvorrichungen verbunden, die den Bewegungsablauf, das Geschwindigkeitsprofil der Aufnahmen 1 und 2 und/oder die Relativbewegungen der Aufnahme 1 und 2 zueinander vornehmen und steuern. Vorteilhafte Ausführungsformen derartiger Antriebsvorrichtungen und Hubeinrichtungen sind insbesondere in der DE 135 46 990 A1 derselben Anmelderin beschrieben. Um Wiederholungen zu vermeiden, wird auf diese Druckschrift verwiesen.

Die Erfindung wurde zuvor anhand einer Ausführungsform unter Bezugnahnme auf schematische Figuren beschrieben. Dem Fachmann sind jedoch zahlreiche Abwandlungen oder Ausgestaltungen und Modifikationen möglich, ohne daß dadurch der Erfindungsgedanke verlassen wird. Beispielsweise ist das erfindungsgemäße Verfahren und die erfindungsgemäße Vorrichtung auch im Zusammenhng mit Substraten anwendbar, die nicht quadratisch oder rechteckig sind, sondern eine andere Form, beispielsweise eine Scheibenform aufweisen. Auch ist es möglich, die Aufnahmen 1, 2 je nach den Gegebenheiten unterschiedlich auszubilden. Die erste Aufnahme 1 kann darüber hinaus gegebenenfalls auch unterhalb der Fluidoberfläche 8 bleiben und nicht über sie angehoben werden.

## Patentansprüche

1. Verfahren zum Behandeln von Substraten (3), die in einem Behandlungsfluid (8) behandelt und mit einer Hubvorrichtung ein- und ausgehoben werden, wobei die Substrate (3) mit einer ersten Aufnahme (1) teilweise aus dem Behandlungsfluid (9) herausgehoben, und danach von einer zweiten Aufnahme (2) übernommen und vollständig aus dem Behandlungsfluid (8) herausgehoben werden, die beim Übernehmen der Substrate (3) trocken ist, dadurch gekennzeichnet, daß sich an der tiefsten Stelle der Substrate (3) bildende Tropfen abgeleitet werden.

2. Verfahren nach Anspruch 1, dadurch gekennzeichnet, daß die zweite Aufnahme (2) getrocknet wird, bevor sie die Substrate (3) übernimmt.

3. Verfahren nach einem der Ansprüche 1 oder 2, dadurch gekennzeichnet, daß die erste und zweite Aufnahme (1, 2) in vertikaler Richtung relativ zueinander bewegt werden.

4. Verfahren nach einem der vorhergehenden Ansprüche, dadurch gekennzeichnet, daß die Substrate (3) beim Beladen in oder auf die zweite Aufnahme (2) gebracht werden.

5. Verfahren nach einem der vorhergehenden Ansprüche, dadurch gekennzeichnet, daß die Substrate (3) beim Entladen aus oder von der zweiten Aufnahme (2) entnommen werden.

6. Verfahren nach einem der vorhergehenden Ansprüche, dadurch gekennzeichnet, daß die Substrate (3) und/oder die erste und/oder die zweite Aufnahme (1, 2) beim Ausfahren aus dem Behandlungsfluid (8) mit einem Gas beaufschlagt werden.

7. Verfahren nach Anspruch 6, dadurch gekennzeichnet, daß das Gas Isopropylalkohol, Stickstoff oder eine daraus gebildete Gasmischung ist.

8. Vorrichtung zum Behandeln von Substraten (3) in einem Behandlungsfluid (8), mit einer Hubvorrichtung, wobei eine erste Aufnahme (1) zum teilweisen Ausheben der Substrate (3) aus dem Behandlungsfluid (8) und eine zweite Aufnahme (2) zum Übernehmen der Substrate (3)vorgesehen ist, und wobei die zweite Aufnahme (2) beim Übernehmen der Substrate trocken ist, gekennzeichnet durch ein Tropfen-Ableitelement (4), das mit der untersten Stelle (10) der Substrate (3) in Kontakt steht, wenn sich die Substrate auf der zweiten Aufnahme (2) befinden.

9. Vorrichtung nach Anspruch 8, dadurch gekennzeichnet, daß die Substrate (3) rechteckig sind und die unterste Stelle (10) der Substrate (3) eine Ecke (4) des Substrats (3) ist.

10. Vorrichtung nach einem der Ansprüche 8 oder 9, dadurch gekennzeichnet, daß die erste und zweite Aufnahme (1, 2) mit jeweils einem Transportschlitten verbunden ist.

11. Vorrichtung nach Anspruch 10, dadurch gekennzeichnet, daß die Transportschlitten bzw. die erste und zweite Aufnahme (1, 2) in vertikaler Richtung relativ zueinander bewegbar sind.

## Claims

1. Method of treating substrates (3), which are treated in a treatment fluid (8) and lifted in and lifted out by a lifting device, wherein the substrates (3) are raised partially out of the treatment fluid (9) by a first receiver (1) and thereafter taken over and lifted completely out of the treatment fluid (8) by a second receiver (9) which is dry at the takeover of the substrates (3), characterised in that drops forming at the deepest place of the substrates (3) are taken away.

2. Method according to claim 1, characterised in that the second receiver (2) is dried before it takes over the substrates (3).

3. Method according to one of claims 1 and 2, characterised in that the first and second receivers (1, 2) are moved relative to one another in vertical direction.

4. Method according to one of the preceding claims, characterised in that, for loading, the substrates (3) are brought into or onto the second receiver (2).

5. Method according to one of the preceding claims, characterised in that, for unloading, the substrates (3) are taken out of or from the second receiver (2).

6. Method according to one of the preceding claims, characterised in that the substrates (3) and/or the first and/or the second receiver (1, 2) is or are acted on by a gas during movement out of the treatment fluid (8).

7. Method according to claim 6, characterised in that the gas is isopropylalcohol, nitrogen or a gas mixture formed therefrom.

8. Device for the treatment of substrates (3) in a treatment fluid (8), with a lifting device, wherein a first receiver (1) for partial raising of the substrates (3) out of the treatment fluid (8) and a second receiver (2) for taking over the substrates (3) are provided, and wherein the second receiver (2) is dry on takeover of the substrates, characterised by a drop discharge element (4) which is in contact with the lowermost place (10) of the substrate (3) when the substrates are disposed on the second receiver (2).

9. Device according to claim 8, characterised in that the substrates (3) are rectangular and the lowermost place (10) of the substrates (3) is a corner (4) of the substrate (3).

10. Device according to one of claims 8 and 9, characterised in that the first and second receivers (1, 2) are each connected with a respective transport slide.

11. Device according to claim 10, characterised in that the transport slides or the first and second receivers (1, 2) are movable relative to one another in vertical direction.

## Revendications

1. Procédé de traitement de substrats (3) qui sont traités dans un fluide de traitement (8) et qui sont insérés et sortis avec un dispositif de levage, où les substrats (3) sont sortis avec un premier logement (1) partiellement du fluide de traitement (9) et sont repris ensuite par un deuxième logement (2) et sont sortis complètement du fluide de traitement (8), qui est sec lors de la reprise des substrats (3), caractérisé en ce que des gouttes se formant à l'emplacement le plus bas des substrats (3) sont évacuées.

2. Procédé selon la revendication 1, caractérisé en ce que le deuxième logement (2) est séché avant de prendre en charge les substrats (3).

3. Procédé selon l'une des revendications 1 ou 2, caractérisé en ce que le premier et le deuxième logement (1, 2) sont déplacés dans la direction verticale l'un relativement à l'autre.

4. Procédé selon l'une des revendications précédentes, caractérisé en ce que les substrats (3), lors du chargement, sont placés dans ou sur le deuxième logement (2).

5. Procédé selon l'une des revendications précédentes, caractérisé en ce que les substrats (3) lors du déchargement, sont retirés du deuxième logement (2).

6. Procédé selon l'une des revendications précédentes, caractérisé en ce que les substrats (3) et/ou le premier et/ou le deuxième logement (1, 2), lors de la sortie du fluide de traitement (8), sont chargés en un gaz.

7. Procédé selon la revendication 6, caractérisé en ce que le gaz est de l'alcool isopropylique, de l'azote ou un mélange de gaz formé à partir de ceux-ci.

8. Dispositif pour le traitement de substrats (3) dans un fluide de traitement (8), avec un dispositif de levage, où sont prévus un premier logement (1) pour la sortie partielle des substrats (3) du fluide de traitement (8) et un deuxième logement (2) pour la prise en charge des substrats (3), et où le deuxième logement (2) lors de la reprise des substrats est sec, caractérisé par un élément d'évacuation de gouttes (4) qui est en contact avec l'emplacement le plus inférieur (10) des substrats (3) lorsque les substrats se trouvent sur le deuxième logement (2).

9. Dispositif selon la revendication 8, caractérisé en ce que les substrats (3) sont rectangulaires et que l'emplacement le plus inférieur (10) des substrats (3) est un coin (4) du substrat (3).

10. Dispositif selon l'une des revendications 8 ou 9, caractérisé en ce que les premier et deuxième logements (1, 2) sont reliés à respectivement un chariot de transport.

11. Dispositif selon la revendication 10, caractérisé en ce que les chariots de transport respectivement le premier et le deuxième logement (1, 2) sont déplaçables dans la direction verticale les uns relativement aux autres.
